# EUROPEAN PATENT SPECIFICATION

(11) **EP 4 307 855 B1**
(45) Date of publication and mention of the grant of the patent: **10.09.2025**
(21) Application number: 22924558.4
(22) Date of filing: 08.06.2022
(51) Int. Cl.: H10B 12/00

(54) **SEMICONDUCTOR STRUCTURE AND MANUFACTURING METHOD THEREFOR**
HALBLEITERSTRUKTUR UND HERSTELLUNGSVERFAHREN DAFÜR
STRUCTURE SEMI-CONDUCTRICE ET PROCÉDÉ DE FABRICATION CORRESPONDANT

(30) Priority: 31.05.2022 CN 202210610515
(43) Date of publication of application: 17.01.2024
(73) Proprietor: Changxin Memory Technologies, Inc., Hefei City, Anhui Province 230601 (CN)
(72) Inventor: LIU, Youming, Hefei, Anhui 230601 (CN)
(74) Representative: Lavoix
(86) International application number: PCT/CN2022/097528
(87) International publication number: WO 2023/231059

(56) References cited:
- CN-A- 102 544 016
- CN-A- 110 890 371
- US-A1- 2006 240 622
- US-A1- 2021 159 229
- US-A1- 2022 085 023

## Description

The present disclosure claims the priority to Chinese Patent Application 202210610515.8, titled "SEMICONDUCTOR STRUCTURE AND MANUFACTURING METHOD THEREOF", filed with the China National Intellectual Property Administration (CNIPA) on May 31, 2022.

### Technical Field

The present disclosure relates to the technical field of semiconductors, and in particular to a semiconductor structure and a manufacturing method thereof.

### Background

With the development of semiconductor technologies, the memory, especially, a dynamic random-access memory (DRAM) is widely used in various electronic devices due to its high storage density and fast reading and writing speed.

The DRAM usually includes a plurality of memory cells. Each memory cell includes a transistor and a capacitor. A gate of the transistor is electrically connected to a word line (WL) of the DRAM. The on and off of the transistor is controlled by the voltage on the WL. One of a source and a drain of the transistor is electrically connected to a bit line (BL), and the other is electrically connected to the capacitor. Data information is stored or outputted by the BL.

To reduce the size of the memory and increase its storage density, the capacitor is usually placed horizontally, which facilitates manufacturing a capacitor with a larger slenderness ratio. Correspondingly, the transistors are also placed horizontally. An insulating structure is usually disposed between the gates of transistors to isolate adjacent gates. However, as the quantity of layers of the horizontally stacked transistors increases, the insulating structure between adjacent gates also becomes increasingly high. As a result, the insulating structure is likely to collapse, and the stability of the semiconductor structure is poor. Related technologies are known from

US 2022/085023 A1, which discloses a method of manufacturing a 3D DRAM comprising forming a first insulating layer on a substrate, wherein a plurality of active pillars are arranged at intervals along a first direction and a second direction, and the plurality of active pillars extend along a third direction perpendicular to the first two directions; removing the first insulating layer by etching along the second direction to form a plurality of first trenches extending along the third direction, wherein each of the first trenches exposes the substrate and is located between two adjacent columns of active pillars along the first direction.

### Summary

The invention is set out in the appended set of claims.

### Brief Description of the Drawings

FIG. 1 is a flowchart of forming an insulating structure of a semiconductor structure in the related art;
FIG. 2 is a schematic diagram in which the insulating structure of the semiconductor structure collapses in the related art;
FIG. 3 is a flowchart of a manufacturing method of a semiconductor structure according to an embodiment of the present disclosure;
FIG. 4 is a schematic diagram of a cross section taken along E-E after a first insulating layer is formed according to an embodiment of the present disclosure;
FIG. 5 is a schematic diagram of a cross section taken along F-F after a first insulating layer is formed according to an embodiment of the present disclosure;
FIG. 6 is a schematic diagram of a cross section taken along E-E after a first trench is formed according to an embodiment of the present disclosure;
FIG. 7 is a schematic diagram of a cross section taken along F-F after the first trench is formed according to an embodiment of the present disclosure;
FIG. 8 is a schematic diagram of a cross section taken along E-E after an isolation layer is formed according to an embodiment of the present disclosure;
FIG. 9 is a schematic diagram of a cross section taken along F-F after the isolation layer is formed according to an embodiment of the present disclosure;
FIG. 10 is a schematic diagram of a cross section taken along E-E after a first filling space is formed according to an embodiment of the present disclosure;
FIG. 11 is a schematic diagram of a cross section taken along F-F after the first filling space is formed according to an embodiment of the present disclosure;
FIG. 12 is a schematic diagram of a cross section taken along E-E after a gate structure is formed according to an embodiment of the present disclosure;
FIG. 13 is a schematic diagram of a cross section taken along F-F after the gate structure is formed according to an embodiment of the present disclosure;
FIG. 14 is a schematic diagram of a cross section taken along E-E after a protective layer is formed according to an embodiment of the present disclosure;
FIG. 15 is a schematic diagram of a cross section taken along F-F after the protective layer is formed according to an embodiment of the present disclosure;
FIG. 16 is a schematic diagram of a cross section taken along E-E after a WL plug is formed according to an embodiment of the present disclosure;
FIG. 17 is a frame diagram of a semiconductor structure according to an embodiment of the present disclosure;
FIG. 18 is a schematic diagram of a cross section taken along E-E after a stacked structure is formed according to an embodiment of the present disclosure;
FIG. 19 is a schematic diagram of a cross section taken along F-F after the stacked structure is formed according to an embodiment of the present disclosure;
FIG. 20 is a schematic diagram of a cross section taken along E-E after a second trench is formed according to an embodiment of the present disclosure;
FIG. 21 is a schematic diagram of a cross section taken along F-F after the second trench is formed according to an embodiment of the present disclosure;
FIG. 22 is a schematic diagram of a cross section taken along E-E after a second sacrificial layer is formed according to an embodiment of the present disclosure;
FIG. 23 is a schematic diagram of a cross section taken along F-F after the second sacrificial layer is formed according to an embodiment of the present disclosure;
FIG. 24 is a schematic diagram of a cross section taken along E-E after a support space is formed according to an embodiment of the present disclosure;
FIG. 25 is a schematic diagram of a cross section taken along F-F after the support space is formed according to an embodiment of the present disclosure;
FIG. 26 is a schematic diagram of a cross section taken along E-E after a support layer is formed according to an embodiment of the present disclosure;
FIG. 27 is a schematic diagram of a cross section taken along F-F after the support layer is formed according to an embodiment of the present disclosure;
FIG. 28 is a schematic diagram of a cross section taken along E-E after a second filling space is formed according to an embodiment of the present disclosure; and
FIG. 29 is a schematic diagram of a cross section taken along F-F after the second filling space is formed according to an embodiment of the present disclosure.

### Detailed Description

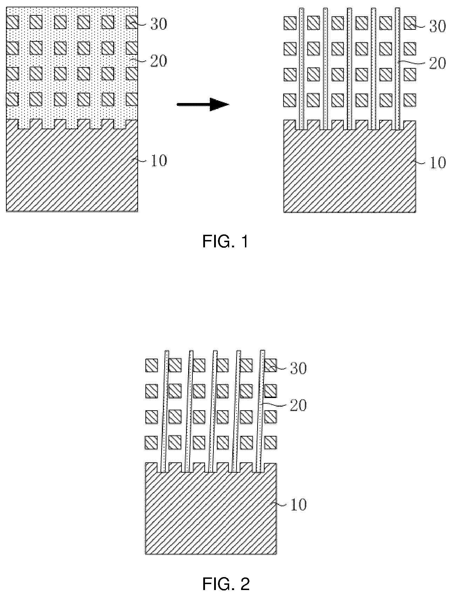

In the related art, due to the poor mechanical property, the insulating structure of the semiconductor structure is likely to collapse, and therefore the stability of the semiconductor structure is poor. With reference to FIG. 1, when the semiconductor structure is manufactured, an insulating structure 20 is usually formed on an active pillar 30. The insulating structure 20 covers the active pillar 30, and they are integrated, to insulate and separate the active pillars 30. Then, the insulating structure 20 is partially removed, to divide it into a plurality of ones. Each insulating structure 20 is located between two adjacent columns of active pillars 30. As shown in FIG. 1, the insulating structure 20 is relatively thin and has the poor mechanical property, and therefore is prone to collapse and deformation, which affects the stability of the semiconductor structure. In addition, with reference to FIG. 2, when the insulating structure 20 collapses, it tends to be in contact with the active pillar 30, and it is difficult for the active pillar 30 to smoothly form a desired structure (for example, a transistor), which affects the performance of the semiconductor structure.

In view of this, the embodiments of the present disclosure provide a semiconductor structure and a manufacturing method thereof. The insulating layer is formed between two adjacent columns of active pillars along the first direction, to separate them, thereby separating the gate structures, on the peripheral surfaces of the active pillars, integrated along the second direction. In addition, the material of the isolation layer is adjusted, to reduce the collapsing possibilities of the isolation layer, thereby improving the stability of the semiconductor structure.

To make the objectives, features and advantages of the embodiments of the present disclosure clearer, the technical solutions in the embodiments of the present disclosure are described clearly and completely below with reference to the drawings in the embodiments of the present disclosure. Apparently, the described embodiments are merely some rather than all of the embodiments of the present disclosure. All other embodiments obtained by those of ordinary skill in the art based on the embodiments of the disclosure without creative efforts shall fall within the protection scope of the present disclosure.

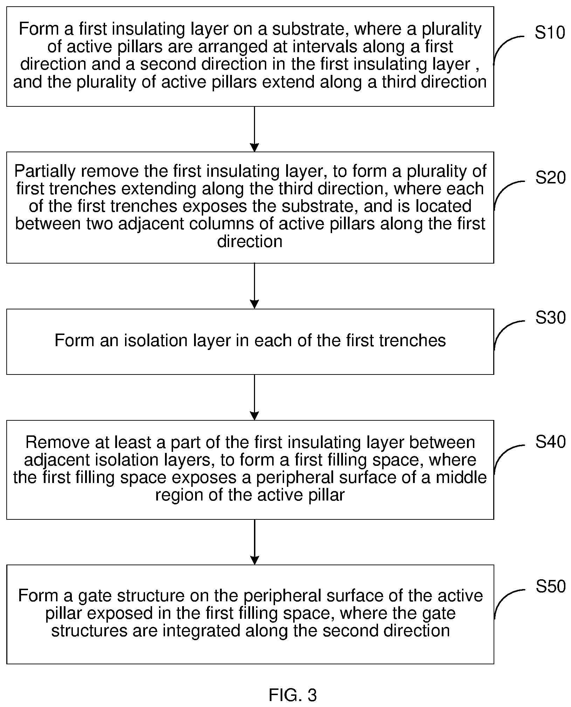

FIG. 3 is a flowchart of a manufacturing method of a semiconductor structure according to an embodiment of the present disclosure. The manufacturing method includes the following steps:
Step S10: Form a first insulating layer on a substrate, where a plurality of active pillars are arranged at intervals along a first direction and a second direction in the first insulating layer, and the plurality of active pillars extend along a third direction.

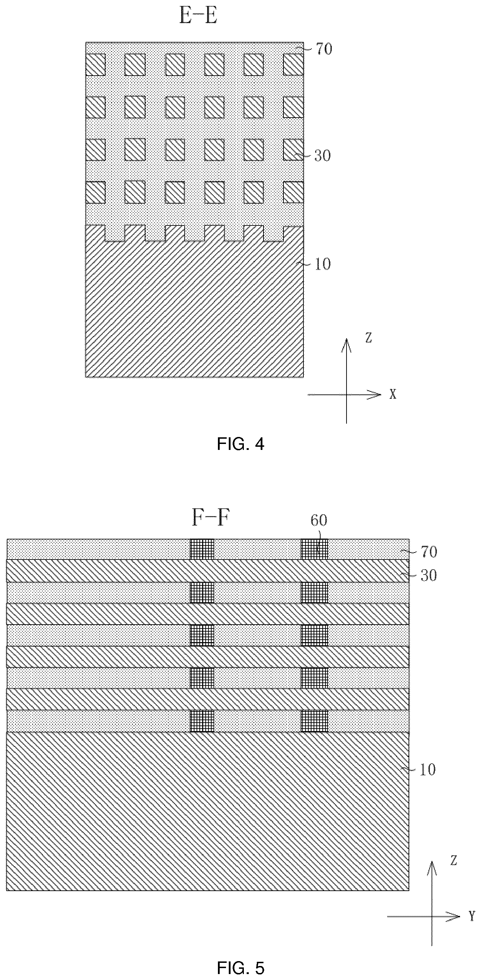

With reference to FIGS. 4 and 5, the section E-E in FIG. 4 is perpendicular to the third direction, and the section F-F in FIG. 5 is parallel to the second direction and passes through the transistor. The substrate 10 can support the structure layers thereon and may be made of a semiconductor such as monocrystalline silicon, polycrystalline silicon, amorphous silicon, germanium, silicon carbide, silicon germanium, germanium on insulator (GOI) or silicon on insulator (SOI).

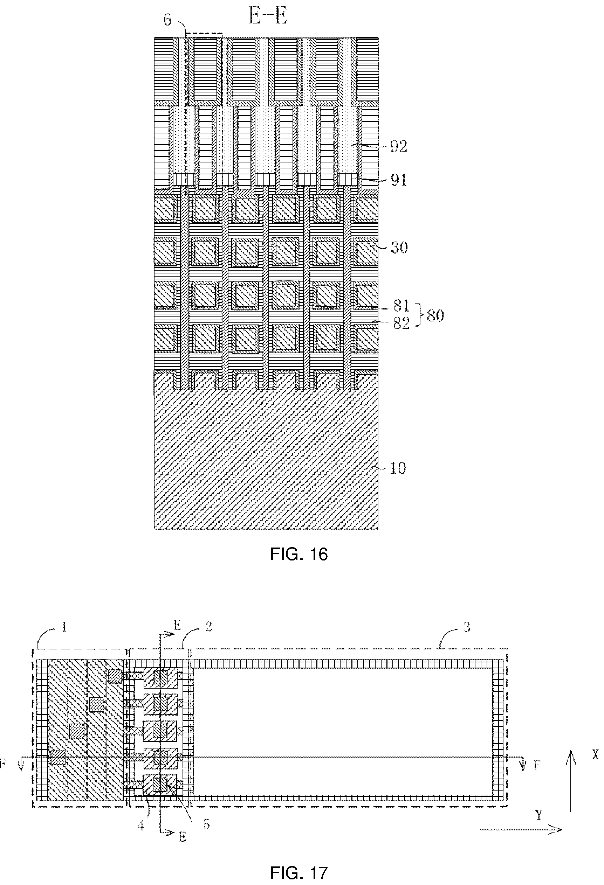

A first insulating layer 70 is formed on the substrate 10. A plurality of active pillars 30 are arranged at intervals in the first insulating layer 70. The active pillar 30 can subsequently form a transistor 2 (refer to FIG. 17). As shown in FIG. 4, the plurality of active pillars 30 are in the first insulating layer 70. The first insulating layer 70 fills a space between adjacent active pillars 30, and therefore separating them. In some possible examples, the first insulating layer 70 covers the plurality of active pillars 30. The surface of the first insulating layer 70 away from the substrate 10 is higher than that of the active pillar 30 away from the substrate 10, such that the plurality of active pillars 30 are located in the first insulating layer 70. The material of the first insulating layer 70 may be an oxide, such as silicon oxide, to facilitate the subsequent removal of the first insulating layer 70.

With reference to FIGS. 4 and 5, the plurality of active pillars 30 extend along the third direction and are arranged in an array. The plurality of active pillars 30 are arranged at intervals in both the first direction and the second direction. The two directions cross each other, and are both perpendicular to the third direction. The third direction is the direction parallel to the substrate 10, that is, the direction Y shown in FIG. 5. The second direction is the direction perpendicular to the substrate 10, that is, the direction Z shown in FIG. 5.

Any two of the first direction, the second direction, and the third direction are perpendicular to each other. For example, the first direction is the direction Z in FIG. 4. Though such a disposal, the plurality of active pillars 30 can be arranged more compact in a better manner, and the arrangement quantity of the active pillars 30 can be maximized, thereby improving storage density of the semiconductor structure.

In some possible embodiments, the active pillar 30 includes a source, a drain, and a channel located between the source and the drain, that is, the source, the channel, and the drain are arranged sequentially along the third direction. It can be understood that the source and the drain are located at two ends of the active pillar 30 respectively. One of the source and the drain is electrically connected to the BL 1 (refer to FIG. 17), and the other is electrically connected to the capacitor 3 (refer to FIG. 17). The channel is located in the middle region of the active pillar 30.

Step S20: Partially remove the first insulating layer, by etching along the second direction, to form a plurality of first trenches extending along the third direction, where each of the first trenches exposes the substrate, and is located between two adjacent columns of active pillars along the first direction.

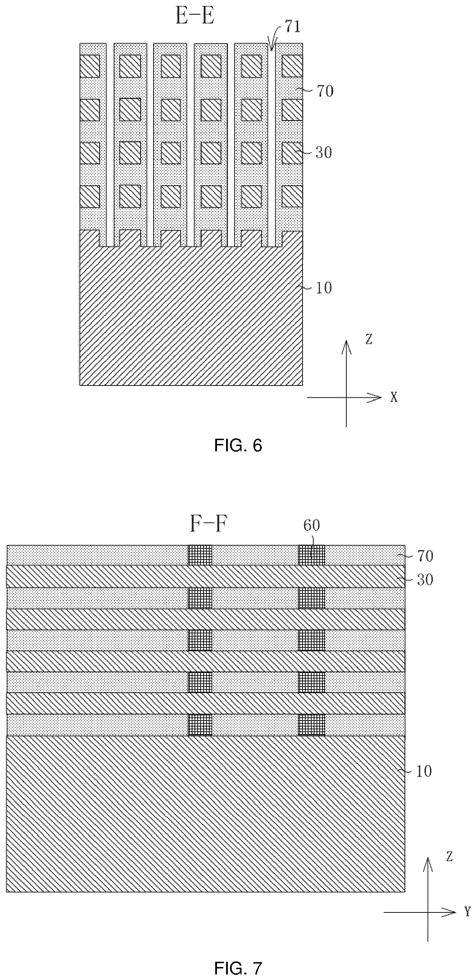

With reference to FIGS. 6 and 7, the first insulating layer 70 is partially removed through dry etching along the second direction Z to form the first trenches 71. The plurality of first trenches 71 are provided and arranged at intervals, do not communicate with each other, and do not expose the active pillars 30. The first trench 71 exposes the substrate 10, and is located between two adjacent columns of active pillars 30. The two columns of active pillars 30 are arranged along the first direction. As shown in FIG. 6, the first trench 71 is located between two adjacent columns of active pillars 30 on the left and right.

The plurality of first trenches 71 and the active pillar 30 both extend along the third direction. In some possible embodiments, along the third direction, the first trench 71 may be as long as the active pillar 30, that is, the first trench 71 divides the first insulating layer 70 into a plurality of ones. In some other possible embodiments, along the third direction, the first trench 71 may be shorter than the active pillar 30. The first trench 71 is at least opposite to the middle region of the active pillar 30, that is, the first trench 71 is at least opposite to the channel. The first trench 71 may extend to the source/drain.

In some possible implementations, the step of partially removing the first insulating layer 70, by etching along the second direction (Z), to form the plurality of first trenches 71 extending along the third direction, where each of the first trenches 71 exposes the substrate 10, and is located between two adjacent columns of active pillars 30 along the first direction includes:
forming a second photoresist layer on the first insulating layer 70, where the second photoresist layer is provided with a second pattern, and the second pattern includes a plurality of second etched trenches extending along the third direction. For example, the second photoresist layer is coated on the first insulating layer 70, and a required second pattern is formed in the second photoresist layer by developing and exposing the second photoresist layer. The second pattern includes a plurality of second etched trenches arranged at intervals. The second etch trenches extend along the third direction and partially expose the first insulating layer 70.

After the second photoresist layer is formed, the first insulating layer 70 is etched by the second photoresist layer as a mask, to form the first trench 71. The first insulating layer 70 that is not covered by the second photoresist layer is etched and removed by the second photoresist layer as a mask. The first insulating layer 70 covered by the second photoresist layer is retained. The first trench 71 is formed in the first insulating layer 70.

It should be noted that when the second photoresist layer is used as a mask to etch the first insulating layer 70, the second photoresist layer is also removed. In some possible examples, during the etching on the first insulating layer 70, the second photoresist layer is completely removed, and therefore the second photoresist layer does not need to be removed separately. In some other possible examples, after the first insulating layer 70 is etched, the second photoresist layer partially remains. In this case, the second photoresist layer needs to be removed separately through, for example, an ashing process, to expose the first insulating layer 70.

Step S30: Form an isolation layer in each of the first trenches.

With reference to FIGS. 7 to 9, the isolation layer 72 fills the first trench 71. For example, the isolation layer 72 is formed through a deposition process, such as chemical vapor deposition (CVD), physical vapor deposition (PVD), or atomic layer deposition (ALD).

In some possible implementations, the step of forming the isolation layer 72 in the first trench 71 includes:
depositing the isolation layer 72 in each of the first trenches 71 and on the first insulating layer 70, where the isolation layer 72 fills up the first trench 71 and covers a surface of the first insulating layer 70 away from the substrate 10. The isolation layer 72 fills up the first trench 71 and covers the first insulating layer 70, to form the isolation layer 72. Because the material of the isolation layer 72 is relatively tough, and includes, for example, silicon nitride or silicon oxynitride, the isolation layer has a better mechanical property, and is unlikely to collapse, and the semiconductor structure has a better stability.

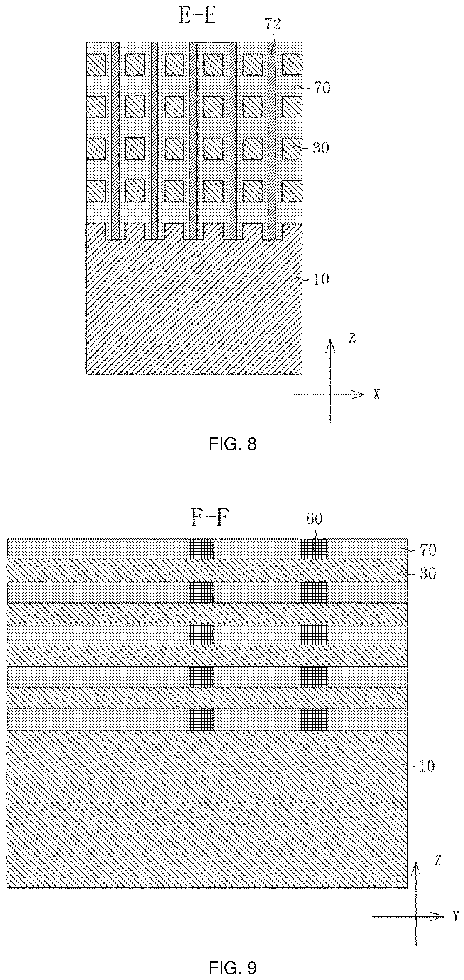

After the isolation layer 72 is deposited, the surface of the isolation layer 72 away from the substrate 10 is flattened to expose the first insulating layer 70. As shown in FIG. 8, the isolation layer 72 is flattened, and the isolation layer 72 located on first insulating layer 70 is removed to expose the first insulating layer 70. For example, a surface of the isolation layer 72 away from the substrate 10 is polished through chemical mechanical polishing (CMP).

Step S40: Remove at least a part of the first insulating layer between adjacent isolation layers, to form a first filling space, where the first filling space exposes a peripheral surface of a middle region of the active pillar.

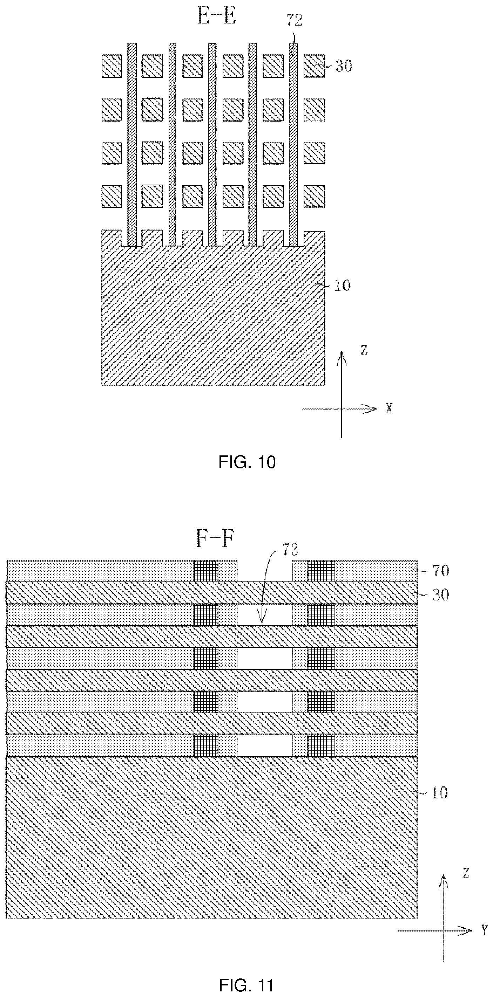

With reference to FIGS. 10 and 11, after the isolation layer 72 is formed, the isolation layer 72 can insulate and isolate two adjacent columns of active pillars 30 along the third direction. In this case, at least a part of the first insulating layer 70 between adjacent isolation layers 72 may be removed, to form a first filling space 73. The peripheral surface of the middle region of the active pillar 30 is exposed in the first filling space 73. The middle region of the active pillar 30 includes the channel of the active region, that is, the first filling space 73 exposes the peripheral surface of the channel, to form the gate structure 80 on the peripheral surface of the channel.

Specifically, in the embodiment in which along the third direction, the first trench 71 is as long as the active pillar 30, a part of the first insulating layer 70 located between the adjacent isolation layers 72 is removed, and the part of the first insulating layer 70 is opposite to the channel. In other words, the removed first insulating layer 70 is shorter than the isolation layer 72 along the third direction. The remaining parts of first insulating layer 70 are located at two ends of the isolation layer 72 along the third direction, to prevent the gate structure from being formed on the entire active pillar 30.

In the embodiment in which along the third direction, the first trench 71 is shorter than the active pillar 30, the first insulating layer 70 located between the adjacent isolation layers 72 is removed partially or completely, to expose the channel. The isolation layer 72 is disposed between adjacent channels, to subsequently insulate and isolate the gate structures in the channels.

Step S50: Form a gate structure on the peripheral surface of the active pillar exposed in the first filling space, where the gate structures are integrated along the second direction.

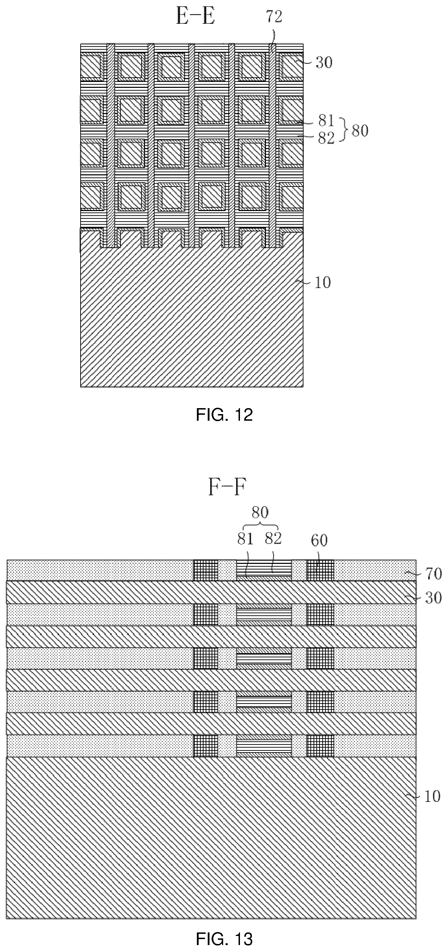

With reference to FIGS. 10 to 13, the gate structure 80 includes a gate dielectric layer 81 and a gate conductive layer 82. The gate dielectric layer 81 covers the peripheral surface of the active pillar 30. The gate conductive layer 82 covers the peripheral surface of the gate dielectric layer 81. The gate conductive layers 82 are integrated along the second direction, to form the WL 4. The material of the gate dielectric layer 81 may include an oxide. The material of the gate conductive layer 82 may include a material with a small resistance, such as W, TiN, TaN, Al, Ru, or Cu.

In some possible implementations, the step of forming the gate structure 80 in the first filling space 73 and on the peripheral surface of the active pillar 30, where the gate structures 80 are integrated along the second direction includes:
forming a gate dielectric layer 81 on the peripheral surface of the active pillar 30, where gaps are formed between the gate dielectric layers 81 and between the gate dielectric layer 81 and the isolation layer 72. For example, the gate dielectric layer 81 is formed on the exposed peripheral surface of the active pillar 30 through a deposition process. The gate dielectric layer 81 covers the active pillar 30. In addition, the gate dielectric layers 81 are spaced apart, and the gate dielectric layer 81 and the isolation layer 72 are also spaced apart from each other.

The gate conductive layer 82 is formed in the remaining first filling space 73, and the gate dielectric layer 81 and the gate conductive layer 82 form the gate structure 80. As shown in FIGS. 11 to 13, the gate conductive layer 82 fills up the remaining first filling space 73, and the gate conductive layers 82 extend and are integrated along the second direction. The gate conductive layer 82 is used as the WL 4. On the one hand, on the basis that the substrate 10 of the same size is occupied, the integration of the semiconductor structure can be improved. On the other hand, the gate conductive layer 82 surrounds the channel, which can also improve the channel control ability of the gate conductive layer 82 and improve the performance of the semiconductor structure.

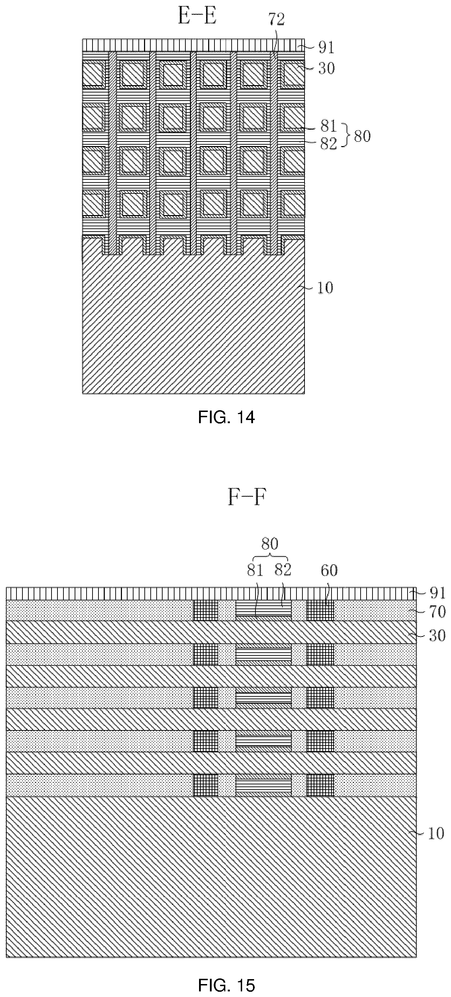

In some possible embodiments, with reference to FIGS. 14 to 17, after the forming the gate structure 80 in the first filling space 73 and on the peripheral surface of the active pillar 30, where the gate structures 80 are integrated along the second direction, the method further includes:
forming a protective layer 91 on the gate structure 80, the first insulating layer 70, and the isolation layer 72, and forming a second insulating layer 92 on the protective layer 91. As shown in FIGS. 14 and 15, the protective layer 91 covers the gate structure 80, the first insulating layer 70, and the isolation layer 72. With reference to FIGS. 16 and 17, the second insulating layer 92 covers the protective layer 91. On the one hand, the protective layer 91 can isolate and protect the gate structure 80, to reduce or prevent oxidation of the gate structure 80. On the other hand, the protective layer can be further used as an etching stop layer for the second insulating layer 92, to reduce or prevent the damages on the gate structure 80 during the etching. The material of the second insulating layer 92 may be silicon oxide, and the material of the protective layer 91 may be silicon nitride or silicon oxynitride.

After the second insulating layer 92 is formed, the second insulating layer 92 and the protective layer 91 are etched to form a plurality of WL plug holes arranged at intervals. Each of the WL plug holes exposes one gate structure 80. Specifically, the second insulating layer 92 and the protective layer 91 are wet-etched or dry-etched to form the WL plug holes. The WL plug holes penetrate through the second insulating layer 92 and the protective layer 91, to expose the gate structures 80. The plurality of WL plug holes correspond to the plurality of gate structures 80 one by one.

After the WL plug holes are formed, a WL plug 5 is formed in the WL plug hole. The WL plugs 5 are electrically connected to the gate structures 80 in a one-to-one correspondence. With reference to FIGS. 16 and 17, one WL plug 5 is formed in each WL plug hole. The WL plug 5 is electrically connected to a corresponding gate structure 80.

In conclusion, in the manufacturing method of a semiconductor structure provided by the embodiments of the present disclosure, the first insulating layer 70 located between two adjacent columns of active pillars 30 is partially removed along the first direction, to form the first trench 71 exposing the substrate 10. Further, the isolation layer 72 is formed in the first trench 71, and separates two adjacent columns of active pillars 30, thereby separating the gate structures 80, on the peripheral surfaces of the active pillars 30, integrated along the second direction. In addition, the material of the isolation layer 72 is adjusted, to reduce the possibilities that the isolation layer 72 collapses, thereby improving the stability of the semiconductor structure.

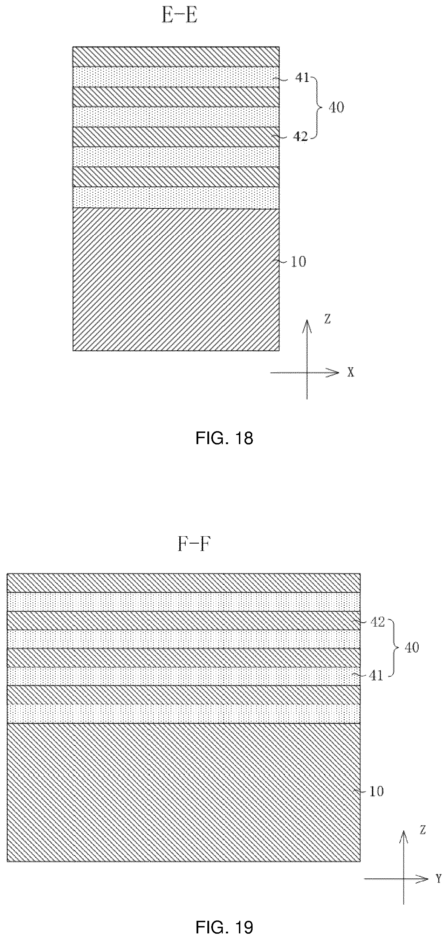

With reference to FIGS. 18 to 19, in a possible embodiment of the present application, the step of forming the first insulating layer 70 on the substrate 10, where the plurality of active pillars 30 arranged at intervals in the first insulating layer 70 along the first direction and the second direction, and the plurality of active pillars 30 extend along the third three direction (step S10) includes the following steps:
Step S11: Form a stacked structure 40 on the substrate 10, where the stacked structure 40, includes a first sacrificial layer 41 and an active layer 42 that are disposed alternately along the second direction.

With reference to FIGS. 18 and 19, the stacked structure 40 includes a plurality of first sacrificial layers 41 and a plurality of active layers 42. The plurality of first sacrificial layers 41 and the plurality of active layers 42 are stacked alternately along the second direction. The second direction is the direction perpendicular to the substrate 10, that is, the direction Z shown in FIG. 18. Along the second direction, the active layer 42 is disposed between two adjacent first sacrificial layers 41, or the first sacrificial layer 41 is disposed between two adjacent active layers 42, such that the first sacrificial layers 41 and the active layers 42 are disposed alternately. In this arrangement, two adjacent active layers 42 can be isolated by the first sacrificial layer 41, to electrically isolate the first active layers 42 along the first direction.

Specifically, an innermost layer in the stacked structure 40 close to the substrate 10 is the first sacrificial layer 41, and an outermost layer in the stacked structure 40 away from the substrate 10 is the active layer 42. In this way, on the one hand, the innermost first sacrificial layer 41 can separate the active layer 42 on the first sacrificial layer 41 from the substrate 10, and therefore, each active layer 42 can form the active pillars 30 subsequently, thereby increasing the storage capacity of the semiconductor structure. On the other hand, when the stacked structures 40 have the same quantity of active layers 42, the height of the stacked structure 40 is reduced to facilitate the subsequent etching of the stacked structure 40.

In some possible implementations, the first sacrificial layer 41 and the active layer 42 may be formed on the substrate 10 through an epitaxy process. Specifically, the substrate 10, the active layer 42, and the first sacrificial layer 41 are made of the same element, such as the silicon element, such that the first sacrificial layer 41 is epitaxially formed on the substrate 10, the active layer 42 is epitaxially formed on the first sacrificial layer 41, and the first sacrificial layer 41 is epitaxially formed on the active layer 42. For example, the material of the substrate 10 includes silicon. The material of the active layer 42 includes silicon. The material of the first sacrificial layer 41 includes silicon germanium. In this way, the active layer 42 and the first sacrificial layer 41 are epitaxially formed. Further, the first sacrificial layer 41 and the active layer 42 each have a larger selectivity ratio, and the first sacrificial layer 41 may be subsequently removed separately to reduce damage on the active layer 42 when the first sacrificial layer 41 is removed. In some embodiments, the material of the active layer 42 includes doped silicon. For example, the material of the active layer 42 includes N-type doped silicon, to improve the electrical performance of the active layer 42.

Step S12: Etch the stacked structure 40, to form a plurality of second trenches 43 arranged at intervals and extending along the third direction, where the second trenches 43 expose the substrate 10, and divide the active layer 42 into the plurality of active pillars 30.

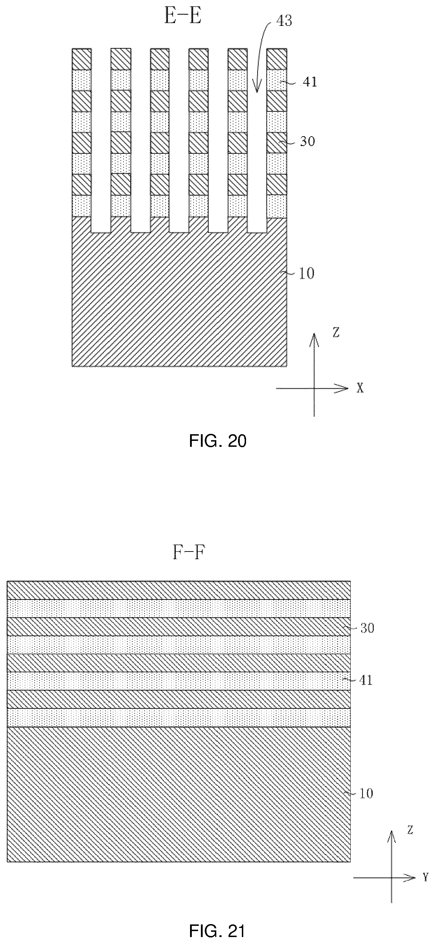

With reference to FIGS. 20 and 21, the plurality of second trenches 43 are formed in the stacked structure 40, and the plurality of second trenches 43 are arranged at intervals and extend along a third direction. The third direction is the horizontal direction (the direction Y) shown in FIG. 21. The third direction is parallel to the substrate 10 and perpendicular to the second direction. The second trench 43 penetrates the stacked structure 40 to expose the substrate 10.

In some possible embodiments, with reference to FIG. 20, the second trench 43 may further extend into the substrate 10, that is, the bottom of the second trench 43 is located in the substrate 10. In this way, on the one hand, it can ensure that the second trenches 43 divide the stacked structure 40 into a plurality of parts, such that each active layer 42 in the stacked structure 40 is divided into a plurality of active pillars 30 arranged at intervals, thereby improving the quantity of the active pillars 30, and increasing the storage capacity of the semiconductor structure. On the other hand, it can ensure that the second trench 43 penetrates through all the first sacrificial layers 41 to facilitate the subsequent removal of the first sacrificial layer 41.

Step S13: Remove the first sacrificial layer 41 to form a second filling space 61.

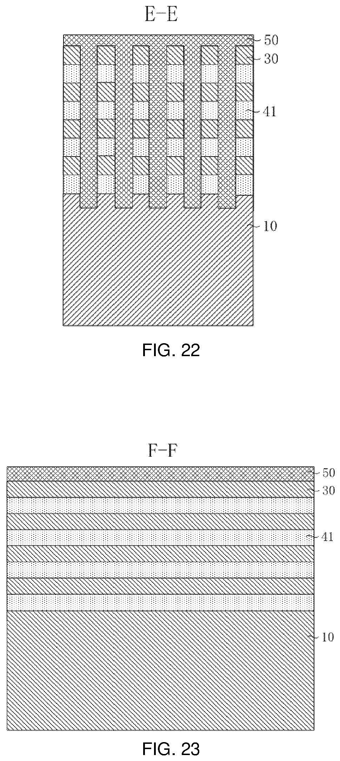

With reference to FIG. 22, in some possible implementations, the step of removing the first sacrificial layer 41, to form the second filling space 61 includes:
depositing a second sacrificial layer 50 in the second trench 43 and on the stacked structure 40, where the second sacrificial layer 50 fills up the second trench 43 and covers a surface of the stacked structure 40 away from the substrate 10. As shown in FIGS. 22 and 23, the second sacrificial layer 50 fills up the second trench 43 and covers the upper surface of the stacked structure 40. After the depositing a second sacrificial layer 50 in the second trench 43 and on the stacked structure 40, where the second sacrificial layer 50 fills up the second trench 43 and covers the stacked structure 40, the method further includes: flattening the surface of the second sacrificial layer 50 away from the substrate 10, such that the upper surface of the second sacrificial layer 50 is flat for the subsequent manufacturing.

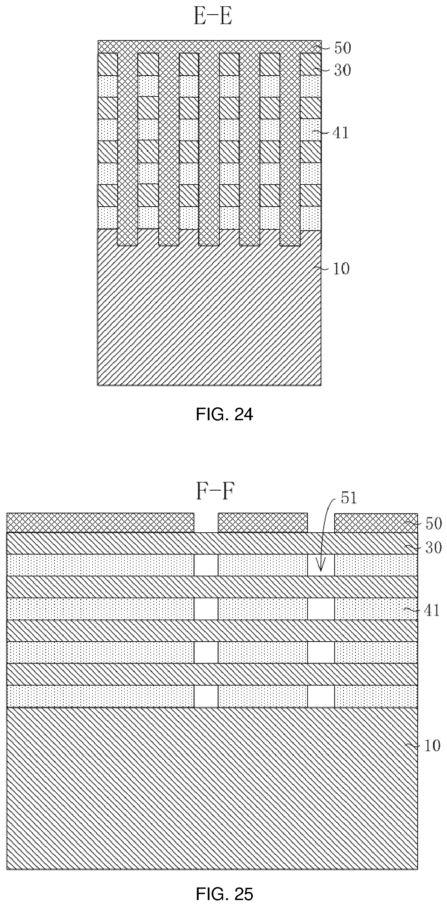

After the second sacrificial layer 50 is formed, the second sacrificial layer 50 and the first sacrificial layer 41 are partially removed, to form at least two support spaces 51 arranged at intervals along the third direction, where the at least two support spaces 51 divide each of the active pillars 30 into a plurality of regions. With reference to FIGS. 24 and 25, for example, two support spaces 51 are provided, and can divide the active pillars 30 into three regions along the third direction. The three regions may be a BL region, a transistor region, and a capacitor region respectively, where the capacitor region is located between the two support spaces 51. Certainly, more support spaces 51 may be provided.

For example, the step of partially removing the second sacrificial layer 50 and the first sacrificial layer 41, to form at least two support spaces 51 arranged at intervals along the third direction, where the at least two support spaces 51 divide each of the active pillars 30 into the plurality of regions includes: forming a first photoresist layer on the second sacrificial layer 50, where the first photoresist layer is provided with a first pattern, and the first pattern includes at least two first etched trenches extending along the first direction; etching the second sacrificial layer 50 by the first photoresist layer as a mask, to form a plurality of etched holes arranged at intervals; and removing the first sacrificial layer 41 between two adjacent ones of the etched holes along the first direction, such that the etched holes arranged along the first direction communicate, to form the support space 51.

The first photoresist layer may be formed on the second photoresist layer through, for example, a spin coating process, and the first etched trench exposes a part of the second sacrificial layer 50. The etched hole formed by etching the second sacrificial layer 50 penetrates through the second sacrificial layer 50 and exposes the substrate 10, the active pillar 30 and the first sacrificial layer 41. The first sacrificial layer 41 can be removed by the etched hole. Specifically, the first sacrificial layer 41 exposed in the etched hole is wet-etched, such that the etched holes arranged along the first direction communicate to form a support space 51, and the support spaces 51 are arranged at intervals along the third direction.

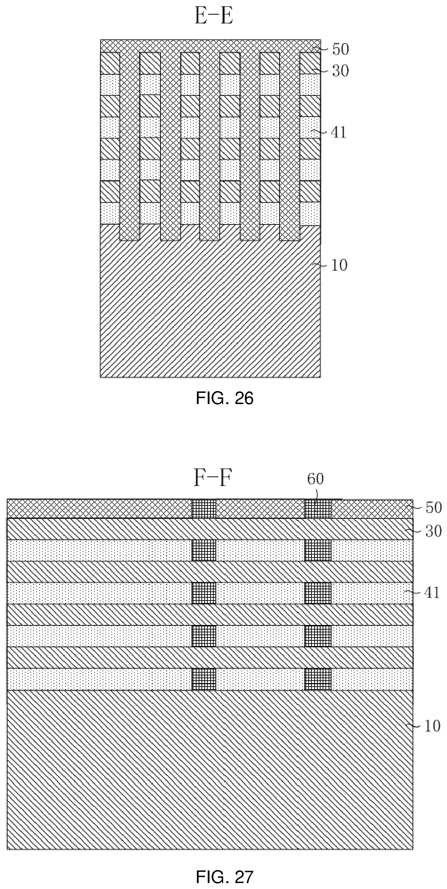

After the support space 51 is formed, a support layer 60 is formed in each of the support spaces 51. With reference to FIGS. 25 to 27, the support layer 60 is deposited in each filling space. The support layers 60 are arranged at intervals along the third direction, and the material of the support layer 60 may be silicon nitride. It can be understood that a plane parallel to the third direction is used as a cross section, and a cross-sectional shape of the support layer 60 is in a shape of a net.

After the support layer 60 is formed, the remaining second sacrificial layer 50 and the remaining first sacrificial layer 41 are removed to form a second filling space 61. For example, the remaining second sacrificial layer 50 is wet etched, to expose the second trench 43, and continuously, the remaining first sacrificial layer 41 is removed through the wet etching by the second trench 43, thereby forming the second filling space 61. The second filling space 61 includes the second trench 43.

Step S14: Deposit the first insulating layer 70 in the second filling space 61.

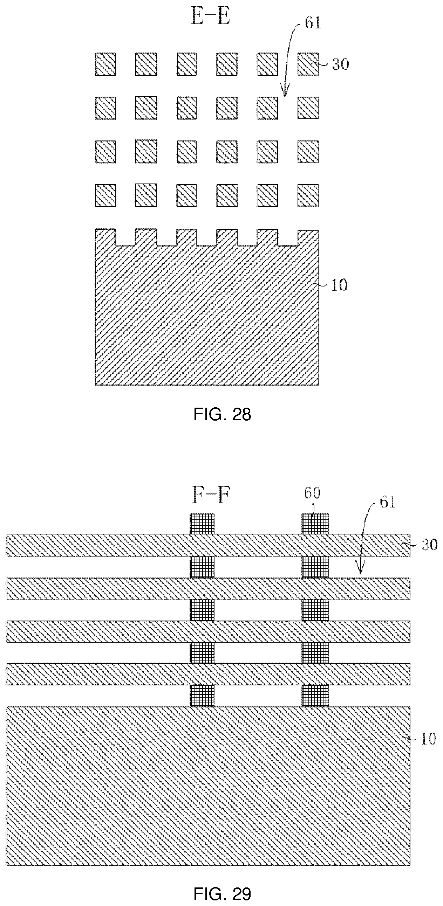

With reference to FIGS. 4, 5, 28, and 29, the first insulating layer 70 fills up the second filling space 61. In some possible implementations, the step of depositing the first insulating layer 70 in the second filling space 61 includes:
depositing the first insulating layer 70 in the second filling space 61 and on the stacked structure 40, where the first insulating layer 70 fills up the second filling space 61 and covers a surface of the stacked structure 40 away from the substrate 10. As shown in FIGS. 4 and 28, the first insulating layer 70 fills up the second filling space 61 and covers the upper surface of the stacked structure 40.

The surface of the first insulating layer 70 away from the substrate 10 is flattened. As shown in FIG. 4, after the flattening processing, the surface of the first insulating layer 70 away from the substrate 10 is relatively flat, such that another structure layer is formed thereon. In addition, the active pillar 30 is not exposed. The first insulating layers 70 may be reduced or the active pillar 30 is oxidized

It should be noted that, in some possible embodiments, the plurality of isolation layers 72 are each located between two same adjacent support layers 60. A gap is formed between the isolation layer 72 and the support layer 60. The step of removing at least a part of the first insulating layer 70 between adjacent isolation layers 72, to form the first filling space 73, where the first filling space 73 exposes the peripheral surface of the middle region of the active pillar 30 includes: completely removing the first insulating layer 70 between adjacent isolation layers 72 and opposite to the isolation layer 72, to form the first filling space 73.

Along the third direction, at least two support layers 60 are formed on the substrate 10. The active pillars 30 penetrate through the at least two support layers 60. In the at least two support layers 60, a plurality of isolation layers 72 are disposed between a set of two adjacent support layers 60. In some possible examples, a set of two adjacent support layers 60 are arranged along the third direction, and a plurality of isolation layers 72 are disposed between the two support layers 60. In some other possible examples, three support layers 60 are disposed along the third direction. The third support layers 60 include two sets of two adjacent support layers 60. A plurality of isolation layers 72 are disposed between one of the two sets of the support layers 60.

A gap is formed between support layers 60 at two ends of the isolation layer 72 along the third direction. In addition, the first insulating layer 70 between adjacent isolation layers 72 and opposite to the isolation layer 72 is completely removed, to form the first filling space 73. Along the third direction, the isolation layer 72 is as long as the first filling space 73.

Finally, it should be noted that the foregoing embodiments are used only to explain the technical solutions of the present disclosure, but are not intended to limit the present disclosure. Although the present disclosure is described in detail with reference to the foregoing embodiments, those of ordinary skill in the art should understand that the scope of the invention is defined by the claims.

## Claims

1. A manufacturing method of a semiconductor structure, **characterized by** comprising:
forming a first insulating layer (70) on a substrate (10), wherein a plurality of active pillars (30) are arranged at intervals along a first direction (X) and a second direction (Z) in the first insulating layer (70), and the plurality of active pillars (30) extend along a third direction (Y) (S10), said third direction (Y) being perpendicular to the first direction (X) and to the second direction (Z);
partially removing the first insulating layer (70), by etching along the second direction (Z), to form a plurality of first trenches (71) extending along the third direction (Y), wherein the plurality of first trenches (71) are provided and arranged at intervals, do not communicate with each other, and do not expose the active pillars (30), and each of the first trenches (71) exposes the substrate (10), and is located between two adjacent columns of active pillars (30) along the first direction (X) (S20);
forming an isolation layer (72) in each of the first trenches (71) (S30);
removing at least a part of the first insulating layer (70) between adjacent isolation layers (72), to form a first filling space (73), wherein the first filling space (73) exposes a peripheral surface of a middle region of the active pillar (30) (S40); and
forming a gate structure (80) on the peripheral surface of the active pillar (30) exposed in the first filling space (73), wherein the gate structures (80) are integrated along the second direction (Z) (S50).

2. The manufacturing method according to claim 1, wherein the forming a first insulating layer (70) on a substrate (10), wherein a plurality of active pillars (30) are arranged at intervals along a first direction (X) and a second direction (Z) in the first insulating layer (70), and the plurality of active pillars (30) extend along a third direction (Y) (S10) comprises:
forming a stacked structure (40) on the substrate (10), wherein the stacked structure (40) comprises a first sacrificial layer (41) and an active layer (42) that are disposed alternately along the second direction (Z);
etching the stacked structure (40), to form a plurality of second trenches (43) arranged at intervals and extending along the third direction (Y), wherein the second trenches (43) expose the substrate (10), and divide the active layer (42) into the plurality of active pillars (30);
removing the first sacrificial layer (41), to form a second filling space (61); and
depositing the first insulating layer (70) in the second filling space (61).

3. The manufacturing method according to claim 2, wherein the removing the first sacrificial layer (41), to form a second filling space (61) comprises:
depositing a second sacrificial layer (50) in the second trench (43) and on the stacked structure (40), wherein the second sacrificial layer (50) fills up the second trench (43) and covers a surface of the stacked structure (40) away from the substrate (10);
partially removing the second sacrificial layer (50) and the first sacrificial layer (41), to form at least two support spaces (51) arranged at intervals along the third direction (Y), wherein the at least two support spaces (51) divide each of the active pillars (30) into a plurality of regions;
forming a support layer (60) in each of the support spaces (51); and
removing the remaining second sacrificial layer (50) and the remaining first sacrificial layer (41), to form the second filling space (61).

4. The manufacturing method according to claim 3, after the depositing a second sacrificial layer (50) in the second trench (43) and on the stacked structure (40), wherein the second sacrificial layer (50) fills up the second trench (43) and covers a surface of the stacked structure (40) away from the substrate (10), the manufacturing method further comprises:
flattening a surface of the second sacrificial layer (50) away from the substrate (10).

5. The manufacturing method according to claim 3, wherein the partially removing the second sacrificial layer (50) and the first sacrificial layer (41), to form at least two support spaces (51) arranged at intervals along the third direction (Y), wherein the at least two support spaces (51) divide each of the active pillars (30) into a plurality of regions comprises:
forming a first photoresist layer on the second sacrificial layer (50), wherein the first photoresist layer is provided with a first pattern, and the first pattern comprises at least two first etched trenches extending along the first direction (X);
etching the second sacrificial layer (50) by the first photoresist layer as a mask, to form a plurality of etched holes arranged at intervals; and
removing the first sacrificial layer (41) between two adjacent ones of the etched holes along the first direction (X), such that the etched holes arranged along the first direction (X) communicate, to form the support space (51).

6. The manufacturing method according to claim 3, wherein the plurality of isolation layers (72) are each located between two same adjacent ones of the support layers (60), and a gap is formed between the isolation layer (72) and the support layer (60); and
the removing at least a part of the first insulating layer (70) between adjacent isolation layers (72), to form a first filling space (73), wherein the first filling space (73) exposes a peripheral surface of a middle region of the active pillar (30) comprises:
completely removing the first insulating layer (70) between adjacent isolation layers (72) and opposite to the isolation layer (72), to form the first filling space (73).

7. The manufacturing method according to claim 2, wherein the depositing the first insulating layer (70) in the second filling space (61) comprises:
depositing the first insulating layer (70) in the second filling space (61) and on the stacked structure (40), wherein the first insulating layer (70) fills up the second filling space (61) and covers a surface of the stacked structure (40) away from the substrate (10); and
flattening a surface of the first insulating layer (70) away from the substrate (10).

8. The manufacturing method according to claim 2, wherein a material of the first sacrificial layer (41) comprises silicon germanium, and a material of the active layer (42) comprises N-type doped silicon; and the first sacrificial layer (41) and the active layer (42) are formed through an epitaxial growth process.

9. The manufacturing method according to claim 2, wherein an innermost layer in the stacked structure (40) close to the substrate (10) is the first sacrificial layer (41), and an outermost layer in the stacked structure (40) away from the substrate (10) is the active layer (42).

10. The manufacturing method according to any one of claims 1 to 9, wherein the partially removing the first insulating layer (70), by etching along the second direction (Z), to form a plurality of first trenches (71) extending along the third direction (Y), wherein each of the first trenches (71) exposes the substrate (10), and is located between two adjacent columns of active pillars (30) along the first direction (X) (S20) comprises:
forming a second photoresist layer on the first insulating layer (70), wherein the second photoresist layer is provided with a second pattern, and the second pattern comprises a plurality of second etched trenches extending along the third direction (Y); and
etching the first insulating layer (70) by the second photoresist layer as a mask, to form the first trench (71).

11. The manufacturing method according to any one of claims 1 to 9, wherein the forming an isolation layer (72) in each of the first trenches (71) (S30) comprises:
depositing the isolation layer (72) in each of the first trenches (71) and on the first insulating layer (70), wherein the isolation layer (72) fills up the first trench (71) and covers the surface of the first insulating layer (70) away from the substrate (10); and
flattening a surface of the isolation layer (72) away from the substrate (10), to expose the first insulating layer (70).

12. The manufacturing method according to any one of claims 1 to 9, wherein the forming a gate structure (80) on the peripheral surface of the active pillar (30) exposed in the first filling space (73), wherein the gate structures (80) are integrated along the second direction (Z) (S50) comprises:
forming a gate dielectric layer (81) on the peripheral surface of the active pillar (30), wherein gaps are formed between the gate dielectric layers (81) and between the gate dielectric layer (81) and the isolation layer (72); and
forming a gate conductive layer (82) in the remaining first filling space (73), and taking the gate dielectric layer (81) and the gate conductive layer (82) as the gate structure (80).

13. The manufacturing method according to any one of claims 1 to 9, after the forming a gate structure (80) on the peripheral surface of the active pillar (30) exposed in the first filling space (73), wherein the gate structures (80) are integrated along the second direction (Z) (S50), the manufacturing method further comprises:
forming a protective layer (91) on the gate structure (80), the first insulating layer (70), and the isolation layer (72), and forming a second insulating layer (92) on the protective layer (91);
etching the second insulating layer (92) and the protective layer (91), to form a plurality of word line plug holes arranged at intervals, wherein each of the word line plug holes exposes one of the gate structures (80); and
forming a word line plug (5) in each of the word line plug holes, wherein the word line plugs (5) are electrically connected to the gate structures (80) in a one-to-one correspondence.

14. The manufacturing method according to any one of claims 1 to 9, wherein a material of the isolation layer (72) comprises silicon nitride or silicon oxynitride.

## Patentansprüche

1. Herstellungsverfahren für eine Halbleiterstruktur, **dadurch gekennzeichnet, dass** es Folgendes umfasst:
Bilden einer ersten Isolierschicht (70) auf einem Substrat (10), wobei eine Vielzahl von aktiven Pfeilern (30) in Intervallen entlang einer ersten Richtung (X) und einer zweiten Richtung (Z) in der ersten Isolierschicht (70) angeordnet sind, und sich die Vielzahl von aktiven Pfeilern (30) entlang einer dritten Richtung (Y) (S10) erstrecken, wobei die dritte Richtung (Y) senkrecht zu der ersten Richtung (X) und der zweiten Richtung (Z) ist;
teilweises Entfernen der ersten Isolierschicht (70) durch Ätzen entlang der zweiten Richtung (Z), um eine Vielzahl von ersten Gräben (71) zu bilden, die sich entlang der dritten Richtung (Y) erstrecken, wobei die Vielzahl von ersten Gräben (71) in Abständen vorgesehen und angeordnet sind, nicht miteinander in Verbindung stehen und die aktiven Pfeiler (30) nicht freilegen, und jeder der ersten Gräben (71) das Substrat (10) freilegt und sich zwischen zwei benachbarten Säulen von aktiven Pfeilern (30) entlang der ersten Richtung (X) (S20) befindet;
Bilden einer Isolationsschicht (72) in jedem der ersten Gräben (71) (S30);
Entfernen mindestens eines Teils der ersten Isolierschicht (70) zwischen benachbarten Isolationsschichten (72), um einen ersten Füllraum (73) zu bilden, wobei der erste Füllraum (73) eine Umfangsfläche eines mittleren Bereichs der aktiven Pfeiler (30) (S40) freilegt; und
Bilden einer Gate-Struktur (80) auf der peripheren Oberfläche der aktiven Pfeiler (30), die in dem ersten Füllraum (73) freiliegt, wobei die Gate-Strukturen (80) entlang der zweiten Richtung (Z) (S50) integriert sind.

2. Herstellungsverfahren nach Anspruch 1, wobei das Bilden einer ersten Isolierschicht (70) auf einem Substrat (10), wobei eine Vielzahl von aktiven Pfeilern (30) in Abständen entlang einer ersten Richtung (X) und einer zweiten Richtung (Z) in der ersten Isolierschicht (70) angeordnet sind, und sich die Vielzahl von aktiven Pfeilern (30) entlang einer dritten Richtung (Y) (S10) erstrecken, Folgendes umfasst:
Bilden einer gestapelten Struktur (40) auf dem Substrat (10), wobei die gestapelte Struktur (40) eine erste Opferschicht (41) und eine aktive Schicht (42) umfasst, die abwechselnd entlang der zweiten Richtung (Z) angeordnet sind;
Ätzen der gestapelten Struktur (40), um eine Vielzahl von zweiten Gräben (43) zu bilden, die in Abständen angeordnet sind und sich entlang der dritten Richtung (Y) erstrecken, wobei die zweiten Gräben (43) das Substrat (10) freilegen und die aktive Schicht (42) in die Vielzahl von aktiven Pfeilern (30) unterteilen;
Entfernen der ersten Opferschicht (41), um einen zweiten Füllraum (61) zu bilden; und
Aufbringen der ersten Isolierschicht (70) im zweiten Füllraum (61).

3. Herstellungsverfahren nach Anspruch 2, wobei das Entfernen der ersten Opferschicht (41), um einen zweiten Füllraum (61) zu bilden, Folgendes umfasst:
Aufbringen einer zweiten Opferschicht (50) in dem zweiten Graben (43) und auf der gestapelten Struktur (40), wobei die zweite Opferschicht (50) den zweiten Graben (43) auffüllt und eine von dem Substrat (10) entfernte Oberfläche der gestapelten Struktur (40) bedeckt;
teilweises Entfernen der zweiten Opferschicht (50) und der ersten Opferschicht (41), um mindestens zwei Trägerräume (51) zu bilden, die in Abständen entlang der dritten Richtung (Y) angeordnet sind, wobei die mindestens zwei Trägerräume (51) jede der aktiven Pfeilern (30) in eine Vielzahl von Bereichen unterteilen;
Bilden einer Trägerschicht (60) in jedem der Trägerräume (51); und
Entfernen der verbleibenden zweiten Opferschicht (50) und der verbleibenden ersten Opferschicht (41), um den zweiten Füllraum (61) zu bilden.

4. Herstellungsverfahren nach Anspruch 3, das nach dem Aufbringen einer zweiten Opferschicht (50) in dem zweiten Graben (43) und auf der gestapelten Struktur (40), wobei die zweite Opferschicht (50) den zweiten Graben (43) auffüllt und eine vom Substrat (10) entfernte Oberfläche der gestapelten Struktur (40) bedeckt, ferner umfasst:
Glätten einer Oberfläche der zweiten Opferschicht (50) weg von dem Substrat (10).

5. Herstellungsverfahren nach Anspruch 3, wobei das teilweise Entfernen der zweiten Opferschicht (50) und der ersten Opferschicht (41), um mindestens zwei Trägerräume (51) zu bilden, die in Abständen entlang der dritten Richtung (Y) angeordnet sind, wobei die mindestens zwei Trägerräume (51) jede der aktiven Pfeilern (30) in eine Vielzahl von Bereichen unterteilen, Folgendes umfasst:
Bilden einer ersten Photoresistschicht auf der zweiten Opferschicht (50), wobei die erste Photoresistschicht mit einem ersten Muster versehen ist und das erste Muster mindestens zwei erste geätzte Gräben umfasst, die sich entlang der ersten Richtung (X) erstrecken;
Ätzen der zweiten Opferschicht (50) durch die erste Photoresistschicht als Maske, um eine Vielzahl von in Intervallen angeordneten geätzten Löchern zu bilden; und
Entfernen der ersten Opferschicht (41) zwischen zwei benachbarten der geätzten Löcher entlang der ersten Richtung (X), sodass die entlang der ersten Richtung (X) angeordneten geätzten Löcher miteinander kommunizieren, um den Trägerraum (51) zu bilden.

6. Herstellungsverfahren nach Anspruch 3, wobei die mehreren Isolationsschichten (72) jeweils zwischen zwei gleichen, benachbarten Trägerschichten (60) angeordnet sind und ein Spalt zwischen der Isolationsschicht (72) und der Trägerschicht (60) gebildet wird; und
das Entfernen mindestens eines Teils der ersten Isolierschicht (70) zwischen benachbarten Isolationschichten (72), um einen ersten Füllraum (73) zu bilden, wobei der erste Füllraum (73) eine periphere Oberfläche eines mittleren Bereichs des aktiven Pfeilers (30) freilegt, Folgendes umfasst:
vollständiges Entfernen der ersten Isolierschicht (70) zwischen benachbarten Isolationsschichten (72) und gegenüber der Isolationsschicht (72), um den ersten Füllraum (73) zu bilden.

7. Herstellungsverfahren nach Anspruch 2, wobei das Aufbringen der ersten Isolierschicht (70) in dem zweiten Füllraum (61) Folgendes umfasst:
Aufbringen der ersten Isolierschicht (70) in dem zweiten Füllraum (61) und auf der gestapelten Struktur (40), wobei die erste Isolierschicht (70) den zweiten Füllraum (61) auffüllt und eine vom Substrat (10) entfernte Oberfläche der gestapelten Struktur (40) bedeckt; und
Glätten einer Oberfläche der ersten Isolierschicht (70) weg von dem Substrat (10).

8. Herstellungsverfahren nach Anspruch 2, wobei ein Material der ersten Opferschicht (41) Siliziumgermanium umfasst und ein Material der aktiven Schicht (42) N-dotiertes Silizium umfasst; und die erste Opferschicht (41) und die aktive Schicht (42) durch einen epitaktischen Wachstumsprozess gebildet werden.

9. Herstellungsverfahren nach Anspruch 2, wobei eine innerste Schicht in der gestapelten Struktur (40) nahe dem Substrat (10) die erste Opferschicht (41) und eine äußerste Schicht in der gestapelten Struktur (40) entfernt vom Substrat (10) die aktive Schicht (42) ist.

10. Herstellungsverfahren nach einem der Ansprüche 1 bis 9, wobei das teilweise Entfernen der ersten Isolierschicht (70) durch Ätzen entlang der zweiten Richtung (Z), um eine Vielzahl von ersten Gräben (71) zu bilden, die sich entlang der dritten Richtung (Y) erstrecken, wobei jeder der ersten Gräben (71) das Substrat (10) freilegt und sich zwischen zwei benachbarten Säulen aktiver Pfeiler (30) entlang der ersten Richtung (X) befindet (S20), Folgendes umfasst:
Ausbilden einer zweiten Photoresistschicht auf der ersten Isolierschicht (70), wobei die zweite Photoresistschicht mit einem zweiten Muster versehen ist und das zweite Muster eine Vielzahl von zweiten geätzten Gräben umfasst, die sich entlang der dritten Richtung (Y) erstrecken; und
Ätzen der ersten Isolierschicht (70) durch die zweite Photoresistschicht als Maske, um den ersten Graben (71) zu bilden.

11. Herstellungsverfahren nach einem der Ansprüche 1 bis 9, wobei das Bilden einer Isolationsschicht (72) in jedem der ersten Gräben (71) (S30) Folgendes umfasst:
Aufbringen der Isolationsschicht (72) in jedem der ersten Gräben (71) und auf der ersten Isolierschicht (70), wobei die Isolationsschicht (72) den ersten Graben (71) auffüllt und die Oberfläche der ersten Isolierschicht (70) weg vom Substrat (10) bedeckt; und
Glätten einer Oberfläche der Isolationsschicht (72) weg vom Substrat (10), um die erste Isolierschicht (70) freizulegen.

12. Herstellungsverfahren nach einem der Ansprüche 1 bis 9, wobei das Bilden einer Gate-Struktur (80) auf der peripheren Oberfläche der aktiven Säule (30), die in dem ersten Füllraum (73) freiliegt, wobei die Gate-Strukturen (80) entlang der zweiten Richtung (Z) (S50) integriert sind, Folgendes umfasst:
Bilden einer dielektrischen Gate-Schicht (81) auf der peripheren Oberfläche der aktiven Säule (30), wobei Lücken zwischen den dielektrischen Gate-Schichten (81) und zwischen der dielektrischen Gate-Schicht (81) und der Isolationsschicht (72) gebildet werden; und
Bilden einer leitfähigen Gate-Schicht (82) in dem verbleibenden ersten Füllraum (73) und Verwenden der dielektrischen Gate-Schicht (81) und der leitfähigen Gate-Schicht (82) als die Gate-Struktur (80).

13. Herstellungsverfahren nach einem der Ansprüche 1 bis 9, wobei nach dem Bilden einer Gate-Struktur (80) auf der peripheren Oberfläche des aktiven Pfeilers (30), die in dem ersten Füllraum (73) freiliegt, wobei die Gate-Strukturen (80) entlang der zweiten Richtung (Z) (S50) integriert sind, das Herstellungsverfahren ferner Folgendes umfasst:
Bilden einer Schutzschicht (91) auf der Gate-Struktur (80), der ersten Isolierschicht (70) und der Isolationsschicht (72) und Bilden einer zweiten Isolierschicht (92) auf der Schutzschicht (91);
Ätzen der zweiten Isolierschicht (92) und der Schutzschicht (91), um eine Vielzahl von Wortleitungs-Stopfenlöchern zu bilden, die in Intervallen angeordnet sind, wobei jedes der Wortleitungs-Stopfenlöcher eine der Gate-Strukturen (80) freilegt; und
Bilden eines Wortleitungsstopfens (5) in jedem der Wortleitungs-Stopfenlöcher, wobei die Wortleitungsstopfen (5) elektrisch mit den Gate-Strukturen (80) in einer Eins-zu-Eins-Entsprechung verbunden sind.

14. Herstellungsverfahren nach einem der Ansprüche 1 bis 9, wobei ein Material der Isolationsschicht (72) Siliziumnitrid oder Siliziumoxynitrid umfasst.

## Revendications

1. Procédé de fabrication d'une structure semi-conductrice, **caractérisé en ce qu'**il comprend :
former une première couche isolante (70) sur un substrat (10), dans laquelle plusieurs piliers actifs (30) sont disposés à intervalles le long d'une première direction (X) et d'une deuxième direction (Z) dans la première couche isolante (70), et la pluralité de piliers actifs (30) s'étend le long d'une troisième direction (Y) (S10), ladite troisième direction (Y) étant perpendiculaire à la première direction (X) et à la deuxième direction (Z) ;
enlever partiellement la première couche isolante (70), par gravure le long de la deuxième direction (Z), pour former une pluralité de premières tranchées (71) s'étendant le long de la troisième direction (Y), dans laquelle la pluralité de premières tranchées (71) sont prévues et disposées par intervalles, ne communiquent pas entre elles et n'exposent pas les piliers actifs (30), et chacune des premières tranchées (71) expose le substrat (10), et est située entre deux colonnes adjacentes de piliers actifs (30) le long de la première direction (X) (S20) ;
former une couche d'isolation (72) dans chacune des premières tranchées (71) (S30) ;
enlever au moins une partie de la première couche isolante (70) entre les couches d'isolation adjacentes (72), pour former un premier espace de remplissage (73), dans lequel le premier espace de remplissage (73) expose une surface périphérique d'une région centrale du pilier actif (30) (S40) ; et
former une structure de grille (80) sur la surface périphérique du pilier actif (30) exposée dans le premier espace de remplissage (73), les structures de grille (80) étant intégrées le long de la deuxième direction (Z) (S50).

2. Procédé de fabrication selon la revendication 1, dans lequel la formation d'une première couche isolante (70) sur un substrat (10), dans laquelle une pluralité de piliers actifs (30) sont disposés par intervalles le long d'une première direction (X) et d'une deuxième direction (Z) dans la première couche isolante (70), et la pluralité de piliers actifs (30) s'étendent le long d'une troisième direction (Y) (S10) comprend :
former une structure empilée (40) sur le substrat (10), dans laquelle la structure empilée (40) comprend une première couche sacrificielle (41) et une couche active (42) qui sont disposées alternativement le long de la deuxième direction (Z) ;
graver la structure empilée (40) pour former une pluralité de secondes tranchées (43) disposées par intervalles et s'étendant le long de la troisième direction (Y), dans laquelle les secondes tranchées (43) exposent le substrat (10) et divisent la couche active (42) en une pluralité de piliers actifs (30) ;
enlever la première couche sacrificielle (41) pour former un deuxième espace de
remplissage (61) ; et
déposer la première couche isolante (70) dans le second espace de remplissage (61).

3. Procédé de fabrication selon la revendication 2, dans lequel l'élimination de la première couche sacrificielle (41), pour former un second espace de remplissage (61) comprend :
déposer une deuxième couche sacrificielle (50) dans la deuxième tranchée (43) et sur la structure empilée (40), la deuxième couche sacrificielle (50) remplissant la deuxième tranchée (43) et recouvrant une surface de la structure empilée (40) à l'écart du substrat (10) ;
enlever partiellement la deuxième couche sacrificielle (50) et la première couche sacrificielle (41), pour former au moins deux espaces de support (51) disposés par intervalles le long de la troisième direction (Y), dans laquelle les au moins deux espaces de support (51) divisent chacun des piliers actifs (30) en une pluralité de régions ;
former une couche de support (60) dans chacun des espaces de support (51) ; et
enlever la seconde couche sacrificielle restante (50) et la première couche sacrificielle restante (41), pour former le second espace de remplissage (61).

4. Procédé de fabrication selon la revendication 3, après le dépôt d'une deuxième couche sacrificielle (50) dans la deuxième tranchée (43) et sur la structure empilée (40), dans lequel la deuxième couche sacrificielle (50) remplit la deuxième tranchée (43) et couvre une surface de la structure empilée (40) à l'écart du substrat (10), le procédé de fabrication comprenant en outre :
aplatir une surface de la seconde couche sacrificielle (50) à l'écart du substrat (10).

5. Procédé de fabrication selon la revendication 3, dans lequel le retrait partiel de la deuxième couche sacrificielle (50) et de la première couche sacrificielle (41), pour former au moins deux espaces de support (51) disposés par intervalles le long de la troisième direction (Y), dans lequel les au moins deux espaces de support (51) divisent chacun des piliers actifs (30) en une pluralité de régions, et comprend :
former une première couche de résine photosensible sur la seconde couche sacrificielle (50), la première couche de résine photosensible étant pourvue d'un premier motif, et le premier motif comprenant au moins deux premières tranchées gravées s'étendant le long de la première direction (X) ;
graver la seconde couche sacrificielle (50) à l'aide de la première couche de résine photosensible servant de masque, afin de former une pluralité de trous gravés disposés par intervalles ; et
retirer la première couche sacrificielle (41) entre deux trous gravés adjacents le long de la première direction (X), de sorte que les trous gravés disposés le long de la première direction (X) communiquent, pour former l'espace de support (51).

6. Procédé de fabrication selon la revendication 3, dans lequel la pluralité de couches d'isolation (72) sont chacune situées entre deux couches de support (60) adjacentes, et un espace est formé entre la couche d'isolation (72) et la couche de support (60) ; et
le retrait d'au moins une partie de la première couche isolante (70) entre les couches d'isolation adjacentes (72), pour former un premier espace de remplissage (73), dans lequel le premier espace de remplissage (73) expose une surface périphérique d'une région centrale du pilier actif (30) comprend :
enlever complètement la première couche isolante (70) entre les couches d'isolation adjacentes (72) et à l'opposé de la couche d'isolation (72), pour former le premier espace de remplissage (73).

7. Procédé de fabrication selon la revendication 2, dans lequel le dépôt de la première couche isolante (70) dans le second espace de remplissage (61) comprend :
déposer la première couche isolante (70) dans le deuxième espace de remplissage (61) et sur la structure empilée (40), la première couche isolante (70) remplissant le deuxième espace de remplissage (61) et couvrant une surface de la structure empilée (40) à l'écart du substrat (10) ; et
aplatir une surface de la première couche isolante (70) à l'écart du substrat (10).

8. Procédé de fabrication selon la revendication 2, dans lequel un matériau de la première couche sacrificielle (41) comprend du silicium germanium, et un matériau de la couche active (42) comprend du silicium dopé de type N ; et la première couche sacrificielle (41) et la couche active (42) sont formées par un processus de croissance épitaxiale.

9. Procédé de fabrication selon la revendication 2, dans lequel la couche la plus interne de la structure empilée (40) proche du substrat (10) est la première couche sacrificielle (41), et la couche la plus externe de la structure empilée (40) éloignée du substrat (10) est la couche active (42).

10. Procédé de fabrication selon l'une quelconque des revendications 1 à 9, dans lequel le retrait partiel de la première couche isolante (70), par gravure le long de la deuxième direction (Z), pour former une pluralité de premières tranchées (71) s'étendant le long de la troisième direction (Y), dans lequel chacune des premières tranchées (71) expose le substrat (10), et est située entre deux colonnes adjacentes de piliers actifs (30) le long de la première direction (X) (S20) et comprend :
former une deuxième couche photorésistante sur la première couche isolante (70), dans laquelle la deuxième couche photorésistante est pourvue d'un deuxième motif, et le deuxième motif comprend une pluralité de deuxièmes tranchées gravées s'étendant le long de la troisième direction (Y) ; et
graver la première couche isolante (70) à l'aide de la deuxième couche de résine photosensible servant de masque, pour former la première tranchée (71).

11. Procédé de fabrication selon l'une quelconque des revendications 1 à 9, dans lequel la formation d'une couche d'isolation (72) dans chacune des premières tranchées (71) (S30) comprend :
déposer la couche d'isolation (72) dans chacune des premières tranchées (71) et sur la première couche isolante (70), la couche d'isolation (72) remplissant la première tranchée (71) et couvrant la surface de la première couche isolante (70) à l'écart du substrat (10) ; et
aplatir une surface de la couche d'isolation (72) à l'écart du substrat (10), afin d'exposer la première couche isolante (70).

12. Procédé de fabrication selon l'une quelconque des revendications 1 à 9, dans lequel la formation d'une structure de grille (80) sur la surface périphérique du pilier actif (30) exposé dans le premier espace de remplissage (73), dans lequel les structures de grille (80) sont intégrées le long de la deuxième direction (Z) (S50) et comprend :
former une couche diélectrique de grille (81) sur la surface périphérique du pilier actif (30), dans laquelle des espaces sont formés entre les couches diélectriques de grille (81) et entre la couche diélectrique de grille (81) et la couche d'isolation (72) ; et
former une couche conductrice de grille (82) dans le premier espace de remplissage restant (73), et prendre la couche diélectrique de grille (81) et la couche conductrice de grille (82) comme structure de grille (80).

13. Procédé de fabrication selon l'une quelconque des revendications 1 à 9, après la formation d'une structure de grille (80) sur la surface périphérique du pilier actif (30) exposé dans le premier espace de remplissage (73), dans lequel les structures de grille (80) sont intégrées le long de la deuxième direction (Z) (S50), le procédé de fabrication comprenant en outre :
former une couche protectrice (91) sur la structure de grille (80), la première couche isolante (70) et la couche d'isolation (72), et former une deuxième couche isolante (92) sur la couche protectrice (91) ;
graver la seconde couche isolante (92) et la couche protectrice (91) pour former une pluralité de trous de bouchon de ligne de mots disposés par intervalles, chacun des trous de bouchon de ligne de mots exposant l'une des structures de grille (80) ; et
former un bouchon de ligne de mots (5) dans chacun des trous de bouchon de ligne de mots, les bouchons de ligne de mots (5) étant connectés électriquement aux structures de grille (80) dans une correspondance biunivoque.

14. Procédé de fabrication selon l'une quelconque des revendications 1 à 9, dans lequel un matériau de la couche d'isolation (72) comprend du nitrure de silicium ou de l'oxynitrure de silicium.
